# EUROPEAN PATENT APPLICATION

(11) **EP 2 378 503 A2**
(43) Date of publication of application: **19.10.2011**
(21) Application number: 11162777.4
(22) Date of filing: 18.04.2011
(51) Int. Cl.: G09F 3/00, G09F 3/02

(54) **Fastener for electronic apparatus and method for manufacturing said fastener**

(30) Priority: 19.04.2010 FI 20105408
(71) Applicant: Ultracom Oy, 90440 Kempele (FI)
(72) Inventor: Valkonen, Hannu, 90120 Oulu (FI)
(74) Representative: Aromaa, Sami Rainer

(57) **Abstract**

This document presents a fastening element for an electronic apparatus to attach the apparatus to a fastening object. The fastening element is manufactures by cutting a piece of desired size from a bar having a cross-section matching the cross-section of the fastening element. The fastening element comprises at least one cavity to which electronic equipment has been mounted, and the fastening element has been designed such that it is adaptable to encircle the fastening object.

## Description

### Field

The invention is directed to a method for manufacturing a fastening element and an electronic apparatus comprising said fastening element with which the apparatus is fastened to a fastening object.

### Background

Nowadays several types of positioning devices are used to determine the location of people, animals, and lifeless objects and to track their movement. Positioning devices may be based on satellite positioning or on location information transmitted by the positioning device itself. Alternatively, the positioning device may transmit a radio signal unique to the positioning device that is detected by radio receiver and signal processing equipment.

With the current technology, the positioning device attachable to an object to be positioned is small-sized and easily portable. According to the prior art, the positioning device is encapsulated in a casing made of injection-moulded plastics, and the casing is attached to a fastening element disposable around the object (e.g. a strap, a vest, a collar) by gluing, stitching inside, etc. Because of the manufacturing technique, such a casing solution is expensive and susceptible to break, because the casing and the fastening element are separate components attached to each other.

### Brief Description

An object of the invention is to realize a manufacturing method for a fastening element and a positioning device comprising such a fastening element effectively and such that the electronics forming the positioning device is protected from breaking.

The invention is directed to an apparatus according to claim 1.

The invention is also directed to a manufacturing method of a fastening element according to claim 6.

Preferred embodiments of the invention are described in dependent claims.

### List of Drawings

The invention is now described in greater detail in connection with preferred embodiments referring to appended drawing in which:
Figure 1A illustrates a homogeneous bar from which fastening elements according to an embodiment of the invention may be cut;
Figure 1B illustrates a fastening element cut from the bar of Figure 1A and electronic equipment installable to the fastening element;
Figures 2A to 2E and 3 illustrate fastening elements according to various embodiments;
Figure 4 illustrates a flow diagram of a manufacturing method of a fastening element and a positioning device; and
Figure 5 illustrates a fastening element according to yet another embodiment of the invention.

### Description of Embodiments

Next, embodiments of the invention are described in detail with reference to appended drawings. The same reference numerals in connection with different drawings refer to the same or corresponding elements or structures.

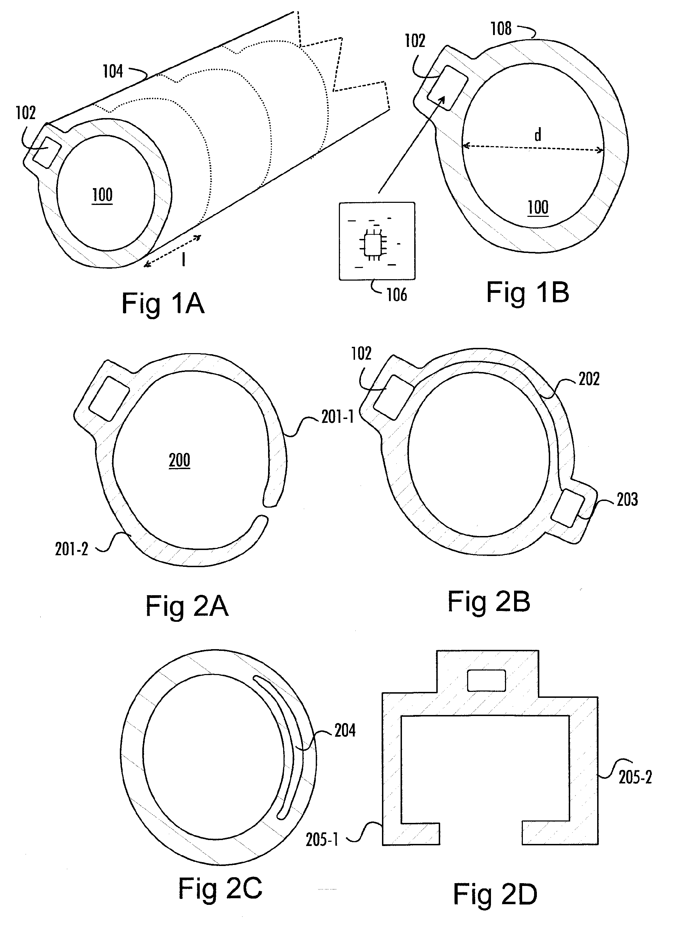

Figure 1A illustrate a bar-like article 104 from which fastening pieces according to embodiments of the invention may be cut. The bar 104 may be a homogeneous bar-like article manufactured by extruding, and the material may be plastics material (e.g. PVC, polyurethane), rubber, metal (e.g. aluminium), or in principle any material depending on the object to which the fastening element is to be fastened. For example, when the fastening object is a living creature, the material is preferable elastic plastic or rubber, while when the fastening object is a pole or a beam, the material may be anything listed above (e.g. metal). The metal material is preferable such that it does not interfere with the operation of electronics (e.g. radio devices). The metal material may be rigid or pliant such as aluminium or tin. Preferably, the material is suitable for extruding, thereby enabling manufacturing of arbitrary long articles having a desired cross-section defined by a nozzle and corresponding to the fastening element. The bar may be hollow or mostly enclosed depending on the material and the desired nozzle piece with which the cross-section of the bar is formed (see Figures 2A to 2E). As shown by dot-lining in Figure 1A, a plurality of fastening elements 108 of Figure 1B having an identical cross-section and desired widths may be cut from the bar 104 manufactured by extruding, wherein the cross-section of each fastening element matches with the cross-section of the bar 104.

A first cavity (or a hole or a recession) 102 extending longitudinally from one end to the other end of the article 104 is arranged in the bar 104, wherein the cavity 102 forms a housing for the electronic equipment 106. The cavity is thus formed inside the fastening element, e.g. insider the cross-section of the fastening element, whereby the fastening element as a homogeneous element provides housing also for the electronic equipment. The measures and design of the first cavity may be arranged to correspond to the measures of the electronic equipment 106. The electronic equipment 106 may according to Figure 1B be a circuit board installed inside the housing 102. The electronic equipment may also be enclosed inside a desired protective material, but it is not necessary to encapsulate with a separate casing structure, because the walls formed by the fastening element function also as the casing and protection for the electronic equipment. When the electronic equipment 106 is installed inside the housing, the ends of the housing 102 that are still exposed are covered with end flanges that enclose the electronic equipment 106 inside the cavity 102. The electronic equipment may comprise electronic components implementing a positioning device, but the electronic equipment may also implement another electronic device. The positioning device may, however, be considered as a preferred embodiment of the electronic equipment, because in applications of the positioning device the device and the fastening element are subjected to stress and impacts caused by motion. The fastening element according to some embodiments of the invention protects the electronic equipment better than an external, separately encapsulated solution.

In this embodiment, the bar 104 comprises another cavity 100 that also extends through the article 104 and that is adapted in its measures to correspond to the measures and/or forms of a fastening object, to which the fastening element is intended to be attached such that, referring to Figure 1B, a diameter d of the second cavity corresponds to the diameter of the fastening object (e.g. a neck of an animal or wrist or ankle of a human). In this embodiment, the second cavity has a circular cross-section having the diameter d, but the second cavity may have oval or any other shape as long as a circumference (or area) formed by the second cavity matches with measures or maximum measures of the fastening object. If the material of the article 104 is elastic, the second cavity may even be dimensioned to be slightly smaller than the fastening object, whereby the attached fastening element is pressed around the fastening object, thereby fastening the fastening element to the fastening object by compressive force.

The width I of the fastening elements cut from the bar 104 (Figure 1A) is also selected to correspond to both the corresponding length of the electronic equipment and the measure of the fastening object. For example, if the fastening object is the neck of an animal, the width of the fastening piece is selected to be sufficiently thin in order not to press the animal's neck and restrict the movement of the head.

Advantages of such fastening pieces that are made of homogeneous material and that include the housing for the electronics, are efficient manufacturing costs and the better protection provided by the uniform structure compared with the separate encapsulation. Better cost-efficiency results from cost-efficient manufacturing method and the fact that both the fastening element and the housing for the electronics are manufactured in a single process.

Figures 2A to 2E illustrate fastening elements according to various embodiments that may be cut from the bar manufactured by extruding that has a cross-section illustrated in Figures 2A to 2E. In practice, the cross-sectional figures of Figures 1A to 2E illustrate also the cross-section of the nozzle of an extruding device (particularly a negative of the nozzle). In the embodiment of Figure 2A, the second cavity 200 is not an enclosed cavity, as was in Figures 1A and 1B, but instead the bar is manufactured to comprise a second cavity 200 that is open at one section. The fastening element of this embodiment may be adapted to fastening objects of many sizes by adjusting the overlapping of strap pieces 201-1 and 201-2 forming the circumference of the second cavity. A locking mechanism (e.g. a buckle) may be arranged to the strap pieces, wherein the locking mechanism locks the strap pieces to each other and around the fastening object.

In the embodiment of Figure 2B, the fastening element comprises to cavities 102, 203 for the electronic equipment. The cavities 102, 203 may be disposed as separated from each other to different sides of the circumferential fastening element. The cavities may have the same size or different sizes depending on the measures of the electronic equipment disposed in them. For example, a batter and/or radio communication equipment may be disposed in one cavity 102, while other electronics may be disposed in the other cavity 203. With respect to the connection between the electronic equipment disposed in the different cavities, a groove 202 for wiring is formed in the in the fastening element (and in the bar). The groove 202 may extend longitudinally through the bar, and preferable on that half of the cross-section where the distance between the cavities 102, 203 is shorter, thus ensuring solid structure of the fastening element. When combining the embodiments of Figures 2A and 2B, the groove 202 is preferably on that side of the fastening element where the material of the fastening element combines the cavities, that is the groove does not extend in the straps 201-1 and 201-2. When installing the electronic equipment into the cavities 102, 203, the wiring there between is installed into the groove, and after that the edges of the groove may be sealed by using, for example, ultrasonic welding, a cover glued over the groove or another sealing method that encloses the groove on both sides, thereby encapsulating the wiring. In an embodiment, an antenna of radio communication equipment is disposed in the groove, whereby the antenna is disposed more diversely on different sides of the fastening element, thereby providing a wider radiation pattern.

In the embodiment of Figure 2C, the fastening element comprises a groove 204 curving according to forms of the fastening element, wherein a bendable circuit board, e.g. a flex circuit board, may be installed into the groove. The electronic equipment is in then implemented by a flex circuit board that may be designed according to the forms of the groove, installed into the groove 204 and, then, open edges of the groove are sealed in order to encapsulate the electronic equipment. An advantage of this embodiment is that the cavity or groove 204 forming the housing for the electronic equipment is as similar in its form with the other design forms of the fastening element, and the encapsulation does not form a separate protrusion. Thus, the electronic equipment is particularly well protected. It should be noted that, in other embodiments, the design of the fastening element may be arranged such that the locations of the cavities 102, 203 do not form such a strong protrusion as shown in Figures 1A to 2B. Then, the thickness of the fastening element may increase (e.g. uniformly) towards the cavities 102, 203.

The fastening elements of Figures 1A to 2C are round-shaped, i.e. they are basically intended to be attached around a round fastening object and to surround the fastening object completely, that is to enclose the fastening object inside the fastening element. In the embodiment of Figure 2D, the fastening element is manufactured of metal, for example, and it is designed to have an angular inner perimeter, thus being applicable for attaching it to an angulated fastening object, e.g. a beam. The fastening element of this embodiment does not necessarily surround the fastening object completely but the enclosure may be incomplete at one edge, as shown in Figure 2D. On this edge, limbs 205-1 and 205-2 of the fastening element may comprise flanges that are disposed around the fastening object to partially enclose the fastening object. The material may be sufficiently plastic such that the limbs 205-1 and 205-2 of the fastening element may be bent around the fastening object but, on the other hand, sufficiently rigid that the fastening element is locked around the fastening object by its form.

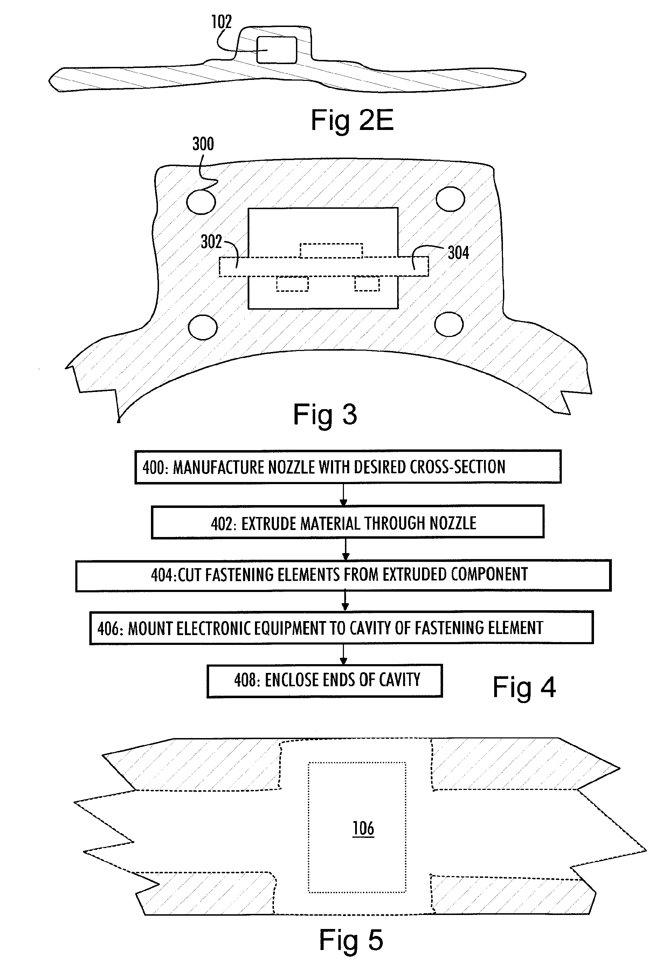

Figure 2E illustrates another embodiment, wherein the fastening element according to Figure 2B has been manufactured with a nozzle having a different cross-section. The material of the fastening element is preferably plastic, elastic, or bendable material. In the embodiment of Figure 2B, the cross-section of the nozzle may be round, but equivalently a nozzle having a different form may be used as long as the result is a fastening element that may be shaped to be attached around the fastening object. In the embodiment of Figure 2E, the nozzle has an elongated cross-section and, in order to encapsulate the electronic equipment, it comprises a protrusion inside which a cavity 102 is formed into the article achieved by extruding.

Figure 3 illustrates a cavity 102 forming the housing of the electronic equipment in greater detail. According to Figure 3, the cavity comprises at least one slot 302, 304 formed of the material of the fastening element on the sides of the cavity, wherein a circuit board forming the electronic equipment may be installed to the slot(s). The circuit board and its components are illustrated in Figure 3 by dashed lines. On the sides of the cavity recessions 302, 304 forming the at least one slot for accommodating the circuit board are formed on the sides of the cavity. The slot provides thus the circuit board with a fastening mechanism, and it prevents the motion of the circuit board inside the cavity. Edge flanges enclosing the edges of the cavity prevent the exposure of the circuit board from the housing.

Into the material of the fastening element on the edges of the cavity (or cavities) for the electronic equipment holes 300 may have been arranged in order to fasten the edge flanges by screws, for example. The design matching the holes may have been made into the extruding nozzle, whereby the holes 300 extend over the length of the article manufactured by extruding, or they may be drilled to the fastening element afterwards. The diameter of the holes 300 is preferable slightly smaller than the diameter of a screw being used.

The edge flanges may have been manufactured of any suitable material, e.g. the material of the fastening element, (extruded plastics), metal plate or fabric. The edge flanges may be attached to over the cavities 102, 203 by gluing, ultrasonic welding, welding, screws or corresponding cleats. The seam between the fastening element and the edge flanges may additionally be sealed by using a waterproof substance.

Figure 4 illustrates a process for manufacturing electronic equipment attachable around a fastening object. The process comprises steps for manufacturing fastening elements according to above-described embodiments and steps for mounting the electronic equipment into the fastening element. It should be noted that different steps are typically made separately and by different operators, and the manufacturing method is not limited to consist of all the steps of Figure 4 but, instead, it may include only some of the steps of Figure 4. Referring to Figure 4, an extruding nozzle having a desired cross-section matching the cross-section of any one of Figures 1B to 2E is manufactured in step 400. The manufacturing of the extruding nozzle as such is known in the field of extruding manufacturing processes. When the nozzle has been mounted to extruding equipment, material is extruded through the nozzle in step 402, wherein the material may be any one of the above-described materials in a liquid form and wherein the material is solidified forming, for example, the bar of Figure 1A having the cross-section matching the cross-section of the nozzle. The cross-section manufactured by extruding thus comprises at least one cavity adapted to have measures matching the measures of the electronic equipment mounted into the cavity, and the cross-section and/or material of the bar is selected such that a fastening element cut from the bar may be fitted to encircle a fastening object. Steps 400 and 402 may be carried out by an instance practicing extruding and manufacturing articles with this technique.

In step 404, a fastening element or a plurality of fastening elements is/are cut from the extruded article. Each fastening element has an identical cross-section, and the width may vary according to the type of the fastening object to which each fastening element is mounted. In step 406, electronic equipment is mounted to at least one (possible multiple) cavity of the fastening element, and edges of the cavity is enclosed in step 408, for example, by gluing or welding to the edges edge flanges to cover the hole or holes of the cavity, as described above.

Figure 5 illustrates yet another embodiment where the width of the electronic equipment 106 is higher than the greatest width of the fastening element adapted to the fastening object. In this case, a piece corresponding to the width of the electronic equipment may be cut from the bar to form the fastening element, and from this cut piece areas shown in Figure 5 by diagonal lining may be cut out such that the material of the fastening piece is wider than elsewhere in an area of the cavity protecting the electronic equipment. Thus, as protective cavity as possible is achieved for the equipment, while reducing the width of the fastening element in those areas where the cavity is not present and, thus, the fastening element may be attached to a thinner fastening object. In other words, the fastening element has a first width in a portion comprising straps encircling the fastening object and a second width higher than the first width in a portion comprising the at least one cavity.

While the invention has been described above by referring to the example of appended drawings, it is apparent that the invention is not limited to that, and it may be modified in various manners within the scope of the appended claims.

## Claims

1. An apparatus comprising:
electronic equipment (106); and
a fastening element (108) for attaching the apparatus to a fastening object,
**characterized in that** the fastening element (108) is manufactured by cutting from a bar (104) having a cross-section matching a cross-section of the fastening element a piece having a desired size, that the fastening element comprises at least one cavity (102, 203) to house the electronic equipment, and that the fastening element is designed to have a form that enables the fastening element to be adapted to encircle the fastening object.

2. The apparatus of claim 1, wherein said at least one cavity (102, 203) comprises on its sides at least one slot (302, 304) formed of the material of the fastening element (108), wherein a circuit board (106) comprised in the electronic equipment is mounted to the at least one slot.

3. The apparatus of claim 1 or 2, wherein at least one edge flange covers open edges of the at least one cavity in order to encapsulate the electronic equipment inside the cavity.

4. The apparatus of any preceding claim 1 to 3, wherein the fastening element comprises as separated from each other at least two cavities (102, 203) to which components of the electronic equipment are mounted to, and between which a groove is formed in the fastening element for at least one electric wire connecting the components of the electronic equipment to each other.

5. The apparatus of any preceding claim 1 to 4, wherein the fastening element is made of homogeneous material.

6. A method for manufacturing a fastening element, the method comprising:
producing (400, 402) an extruded bar (104) having a desired cross-section,
cutting a piece of the bar having a desired size to obtain a fastening element (108),
**characterized in that** the cross-section of the bar comprises at least one cavity (102, 203) adapted to have measures matching measures of electronic equipment (106) mounted to the cavity, and that the cross-section and/or the material of the bar has been selected such that the fastening element is adaptable to encircle a fastening object.

7. The method of claim 6, further comprising: cutting a plurality of fastening elements from the bar (104).

8. The method of claim 6 or 7, further comprising: mounting the electronic equipment inside the cavity (102, 203) of the fastening element.

9. The method of any preceding claim 6 to 8, further comprising:
forming the material of the fastening element on sides of the cavity to comprise at least one slot (302, 304) for mounting a circuit board (106) comprised in the electronic equipment.

10. The method of any preceding claim 6 to 9, wherein the bar (104) is manufactured from homogenous material.
